(19) **Europäisches Patentamt / European Patent Office / Office européen des brevets**

(11) **EP 2 190 029 A1**

(12) **EUROPEAN PATENT APPLICATION**
published in accordance with Art. 153(4) EPC

(43) Date of publication:
**26.05.2010 Bulletin 2010/21**

(21) Application number: **09726325.5**

(22) Date of filing: **09.01.2009**

(51) Int Cl.:
***H01L 31/04*** (2006.01)

(86) International application number:
**PCT/JP2009/050178**

(87) International publication number:
**WO 2009/119129 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.03.2008 JP 2008088595**

(71) Applicant: **Mitsubishi Heavy Industries, Ltd. Tokyo 108-8215 (JP)**

(72) Inventors:
• **SAKAI, Satoshi**
  **Yokohama-shi**
  **Kanagawa 236-8515 (JP)**
• **ASAHARA, Yuji**
  **Yokohama-shi**
  **Kanagawa 236-8515 (JP)**

• **KOBAYASHI, Yasuyuki**
  **Yokohama-shi**
  **Kanagawa 236-8515 (JP)**
• **MORI, Masafumi**
  **Nagasaki-shi**
  **Nagasaki 851-0392 (JP)**
• **TSURUGA, Shigenori**
  **Yokohama-shi**
  **Kanagawa 236-8515 (JP)**
• **YAMASHITA, Nobuki**
  **Nagasaki-shi**
  **Nagasaki 851-0392 (JP)**

(74) Representative: **Henkel, Feiler & Hänzel Patentanwälte**
  **Maximiliansplatz 21**
  **80333 München (DE)**

(54) **PHOTOELECTRIC CONVERSION DEVICE AND METHOD FOR MANUFACTURING THE SAME**

(57)    A photovoltaic device that exhibits improved light absorption properties for the electric power generation layer and a process for producing such a photovoltaic device are provided by optimizing the surface shape of the back surface structure. A photovoltaic device 100 comprising a first transparent electrode layer 2, an electric power generation layer 3, a second transparent electrode layer 6 and a back electrode layer 4 provided sequentially on a substrate 1, wherein the back electrode layer 4 comprises a thin film of silver, and the surface of the second transparent electrode layer 6 on the surface of the back electrode layer 4 has a fine uneven texture, for which the surface area magnification ratio relative to the projected surface area is not less than 10% and not more than 32%. Also, a photovoltaic device comprising a first transparent electrode layer 2, an electric power generation layer 3, a second transparent electrode layer 6 and a back electrode layer 4 provided sequentially on a substrate 1, wherein the back electrode layer 4 comprises a thin film of silver, the back electrode layer-side surface of the second transparent electrode layer 6 has a fine uneven texture, and the second transparent electrode layer 6 comprises needle-like crystals.

FIG. 1

EP 2 190 029 A1

**Description**

Technical Field

The present invention relates to a photovoltaic device and a process for producing the same, and relates particularly to a solar cell that uses silicon as the electric power generation layer.

Background Art

The use of solar cells as photovoltaic devices that receive light and convert the energy into electrical power is already known. Amongst solar cells, thin-film type solar cells in which thin films of silicon-based layers are stacked together to form an electric power generation layer (photovoltaic layer) offer various advantages, including the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells. However, a drawback of thin-film silicon-based solar cells is the fact that the conversion efficiency is lower than that of crystalline solar cells.

In thin-film solar cells, various innovations have been adopted to improve the conversion efficiency, namely the electrical power output. For example, tandem-type solar cells have been proposed in which two photovoltaic cells having different wavelength absorption bands are stacked together, thereby enabling a more efficient absorption of the incident light in order to yield a higher electric power generation efficiency. In such a case, long-wavelength light having a wavelength of 500 nm to 1,000 nm is absorbed by a crystalline silicon layer within the photovoltaic cell, but because the absorption coefficient for the crystalline silicon layer within this long-wavelength band is small, the incident light must be reflected inside the solar cell to lengthen the light path and increase the quantity of light absorbed by the crystalline silicon. Accordingly, in the case of super straight-type solar cells, where the sunlight enters the cell from the side of the transparent substrate, investigations continue to be conducted into improving the structure of the back surface on the opposite side of the electric power generation layer to the light-incident side.

Patent citation 1 discloses a back surface structure in which the back electrode is formed of a metal that exhibits a high reflectance for light in the wavelength band corresponding with the radiation spectrum of sunlight, and a transparent conductive layer is formed between the back electrode and the silicon semiconductor layer. By forming this transparent conductive layer, alloying of the material of the back electrode and the silicon thin films can be prevented, meaning the high reflectance of the back electrode can be maintained and any decrease in the conversion efficiency can be prevented.

Patent Citation 1: Japanese Examined Patent Application, Publication No. Sho 60-41878

Disclosure of Invention

As disclosed in patent citation 1, by focusing on the layer structure and improving the structure of the back surface, improvements can be achieved in the conversion efficiency of solar cells. However, in order to achieve further improvements in the conversion efficiency, modification of the layer structure alone is inadequate.

In those cases where the back surface structure comprises a backside transparent electrode layer and a metal layer (back electrode layer) stacked sequentially on top of the electric power generation layer, the shape of the substrate-side surface of the metal layer conforms to the shape of the surface of the backside transparent electrode layer that contacts the metal layer. In other words, if a fine uneven texture exists at the surface of the backside transparent electrode layer, then the metal layer is deposited with a shape that conforms to that uneven texture. If the substrate-side surface of the metal layer has a fine uneven texture, then the incident light entering from the substrate side is scattered at the substrate-side surface of the metal layer, and this scattered light is absorbed by the electric power generation layer. Accordingly, in order to increase the reflectance at the surface of the metal layer and increase the quantity of light absorbed by the electric power generation layer, the back surface structure must be improved by focusing on the surface shape.

In order to enhance the conductivity, the transparent electrode layer is generally deposited under conditions including a high substrate temperature, for example a substrate temperature within a range from 120 to 200°C. By conducting the deposition under high-temperature conditions, the size of the crystal grains increases, enabling the conductivity of the transparent electrode layer to be increased as a result of improved film quality and a reduction in the quantity of crystal grain boundaries. However, because the deposition is conducted under conditions including a high substrate temperature, crystallization progresses significantly, causing an increase in the crystal grain size. As the crystal grain size increases, the surface shape of the transparent electrode layer reflects the shape of the crystal grains, and develops a fine uneven texture. In other words, a problem arises in that a fine uneven texture is formed on the substrate-side surface of the metal layer.

By optimizing the surface shape of the back surface structure, the present invention provides a photovoltaic device that exhibits improved light absorption properties for the electric power generation layer and a process for producing such a photovoltaic device.

Silver, which has very favorable light reflection properties, is generally used as the material for the back electrode layer. For example, if a thin film of silver is formed on a smooth glass substrate, then an ideal high reflectance (approximately 98%) can be achieved.

However, if a fine uneven texture exists at the surface of the silver thin film, then light absorption via surface plasmon resonance occurs at the surface of the silver thin film (hereafter referred to as "surface plasmon absorption"). If surface plasmon absorption occurs, then light that has entered the device from the substrate side, passed through the electric power generation layer, and reached the silver thin film serving as the back electrode layer is absorbed at the interface between the silver thin film and the backside transparent electrode layer, causing a reduction in the quantity of reflected light entering the electric power generation layer. As a result, the quantity of light absorbed by the electric power generation layer is reduced, and the generated electric current decreases (namely, the conversion efficiency decreases).

The inventors of the present invention focused their attention on the backside transparent electrode layer, and discovered that they were able to increase the generated electric current by controlling and optimizing the surface shape of the backside transparent electrode layer.

In other words, a photovoltaic device of the present invention comprises a first transparent electrode layer, an electric power generation layer, a second transparent electrode layer and a back electrode layer provided sequentially on a substrate, wherein the back electrode layer comprises a thin film of silver, and the back electrode layer-side surface of the second transparent electrode layer has a fine uneven texture, for which the surface area magnification ratio relative to the projected surface area of the back electrode layer-side surface of the second transparent electrode layer is not less than 10% and not more than 32%.

The surface shape of the back electrode-side surface of the second transparent electrode layer (the backside transparent electrode layer) includes a rough uneven shape caused by the texture of the underlying first transparent electrode layer, and an additional fine uneven texture arising as a result of the deposition conditions employed for the second transparent electrode layer. The surface shape of the substrate-side of the back electrode layer is substantially the same as the shape of the back electrode-side surface of the second transparent electrode layer. In this manner, by ensuring that the back electrode-side surface of the second transparent electrode layer has a fine uneven texture for which the surface area magnification ratio relative to the projected surface area is not less than 10% and not more than 32%, light loss due to surface plasmon absorption at the surface of back electrode layer comprising the silver thin film can be reduced to a lower level than that conventionally possible, enabling an increase in the quantity of reflected light. Accordingly, the short-circuit current at the electric power generation layer can be increased. As a result, the output of the photovoltaic device can be increased, and the conversion efficiency can be improved. In the present invention, the surface area magnification ratio ($\Delta S$) is represented by a formula (1) shown below, wherein S represents the three dimensional surface area of the back electrode layer-side surface of the second transparent electrode layer, and So represents the two dimensional projected surface area when the same surface is projected onto a flat plane.

$$\Delta S \ (\%) = \{(S/S_0)-1\} \times 100 \qquad (1)$$

Further, a photovoltaic device according to another aspect of the present invention comprises a first transparent electrode layer, an electric power generation layer, a second transparent electrode layer and a back electrode layer provided sequentially on a substrate, wherein the back electrode layer comprises a thin film of silver, the back electrode layer-side surface of the second transparent electrode layer has a fine uneven texture, and the second transparent electrode layer comprises needle-like crystals.

In this manner, if the back electrode layer-side surface of the second transparent electrode layer has a fine uneven texture, and the second transparent electrode layer comprises needle-like crystals, then the microscopic structure at the surface of the second transparent electrode layer becomes denser, and the height variation within the surface unevenness is reduced, meaning a film of favorable smoothness is obtained. Because the substrate-side surface of the back electrode layer has substantially the same shape, light loss due to surface plasmon absorption at the surface of the back electrode layer comprising the silver thin film can be reduced to a lower level than that conventionally possible, enabling an increase in the quantity of reflected light. Accordingly, the short-circuit current at the electric power generation layer can be increased. As a result, the output of the photovoltaic device can be increased, and the conversion efficiency can be improved.

In this case, the ratio of the length of the needle-like crystals in a direction through the film thickness of the second transparent electrode layer relative to the length of the needle-like crystals in an in-plane direction of the second transparent electrode layer is preferably not less than 2.2.

In this manner, by ensuring that the ratio of the length through the film thickness direction relative to the length in the in-plane direction (namely, the aspect ratio) for the needle-like crystals is not less than 2.2, and preferably not less than 2.5, and even more preferably 2.8 or greater, the microscopic structure at the surface of the second transparent electrode layer becomes denser, and the smoothness of the surface is further improved. As a result, the output and conversion efficiency of the photovoltaic device can be further improved.

In the present invention, the electric power generation layer may comprise two or more cell layers, and at least one intermediate contact layer may be provided between one of the cell layers and another of the cell layers that is closest to said one of the cell layers.

The intermediate contact layer has a light containment-enhancing effect. By providing the intermediate contact layer, the quantity of light reflected from the back electrode layer and the second transparent electrode layer can be increased, thereby enhancing the improvement in the short-circuit current.

A process for producing a photovoltaic device according to the present invention comprises: sequentially forming a first transparent electrode layer, an electric power generation layer, a second transparent electrode layer and a back electrode layer on a substrate, wherein the back electrode layer comprises a silver thin film, and the second transparent electrode layer is formed at a substrate temperature of not less than 20°C and not more than 90°C.

Conventionally, the second transparent electrode layer has been deposited at a substrate temperature within a range from 120 to 200°C. By forming the second transparent electrode layer at a substrate temperature of not less than 20°C and not more than 90°C, and preferably not less than 20°C and not more than 60°C, as in the present invention, the back electrode layer-side surface of the second transparent electrode layer is deposited with a very fine uneven texture with a small height variation, and the surface is close to being smooth. The substrate-side surface of the back electrode layer has substantially the same shape. Accordingly, light loss due to surface plasmon absorption at the surface of the back electrode layer comprising the silver thin film can be reduced, enabling an increase in the quantity of reflected light, and the short-circuit current at the electric power generation layer can be increased. As a result, a photovoltaic device having high conversion efficiency can be obtained.

In the invention described above, the second transparent electrode layer is preferably formed so that the surface area magnification ratio relative to the projected surface area of the back electrode layer-side surface of the second transparent electrode layer is not less than 10% and not more than 32%.

In this manner, by ensuring that the surface area magnification ratio relative to the projected surface area of the back electrode layer-side surface of the second transparent electrode layer is not less than 10% and not more than 32%, the second transparent electrode layer is formed as a surface having superior smoothness. As a result, light loss due to surface plasmon absorption at the surface of the back electrode layer comprising the silver thin film can be reduced, enabling an increase in the quantity of reflected light and an increase in the short-circuit current at the electric power generation layer. Accordingly, a photovoltaic device having high conversion efficiency can be obtained.

In the present invention, the second transparent electrode layer preferably comprises needle-like crystals. In such cases, the ratio of the length of the needle-like crystals in a direction perpendicular to the surface of the second transparent electrode layer relative to the length of the needle-like crystals in an in-plane direction of the second transparent electrode layer is preferably not less than 2.2.

Ensuring that the second transparent electrode layer comprises needle-like crystals makes the microscopic structure at the back electrode-side surface of the second transparent electrode layer denser, and reduces the height variation within the surface unevenness. Therefore, the back electrode-side surface of the second transparent electrode layer exhibits superior smoothness. As a result, light loss due to surface plasmon absorption at the surface of the back electrode layer comprising the silver thin film can be reduced, enabling an increase in the quantity of reflected light and an increase in the short-circuit current at the electric power generation layer. Accordingly, a photovoltaic device having high conversion efficiency can be obtained. In particular, if the ratio of the length in the perpendicular direction relative to the length in the in-plane direction (namely, the aspect ratio) for the needle-like crystals is not less than 2.2, and preferably not less than 2.5, and even more preferably 2.8 or greater, then the microscopic structure at the surface of the second transparent electrode layer becomes denser, and the smoothness of the surface is further improved. As a result, a photovoltaic device having a superior output and conversion efficiency can be obtained.

In a photovoltaic device of the present invention, the back electrode layer-side surface of the second transparent electrode layer has a fine uneven texture, for which the surface area magnification ratio relative to the projected surface area is not less than 10% and not more than 32%. The substrate-side surface of the back electrode layer comprising the silver thin film has substantially the same shape as the back electrode layer-side surface of the second transparent electrode layer. Because the back electrode layer has a substrate-side surface of the above shape, light loss due to surface plasmon absorption at the back electrode layer is reduced, and the quantity of reflected light is increased. Accordingly, the short-circuit current at the electric power generation layer increases, and a photovoltaic device having high conversion efficiency is obtained.

Furthermore, in another aspect of the photovoltaic device of the present invention, the back electrode layer-side surface of the second transparent electrode layer has a fine uneven texture, and the second transparent electrode layer comprises needle-like crystals. As a result, the microscopic structure at the surface of the second transparent electrode layer becomes denser and the height variation within the surface unevenness is reduced, yielding a surface with superior smoothness to conventional surfaces. As a result, light loss due to surface plasmon absorption at the back electrode layer surface is reduced, the quantity of reflected light is increased. Accordingly, a photovoltaic device having high conversion efficiency is obtained.

By forming the second transparent electrode layer at a substrate temperature of not less than 20°C and not more than 90°C, a photovoltaic device can be produced in which the back electrode layer-side surface of the second transparent electrode layer has the shape described above. The surface shape of the second transparent electrode layer is optimized so as to reduce light loss due to surface plasmon absorption at the back electrode layer and increase the quantity of reflected light. As a result, a photovoltaic device having superior output and conversion efficiency can be obtained.

Brief Description of Drawings

[FIG. 1] A cross-sectional view schematically illustrating the structure of a photovoltaic device according to an embodiment of the present invention.

[FIG. 2] A schematic illustration describing an embodiment for producing a solar cell panel, representing a photovoltaic device according to the present invention.

[FIG. 3] A schematic illustration describing an embodiment for producing a solar cell panel, representing a photovoltaic device according to the present invention.

[FIG. 4] A schematic illustration describing an embodiment for producing a solar cell panel, representing a photovoltaic device according to the present invention.

[FIG. 5] A schematic illustration describing an embodiment for producing a solar cell panel, representing a photovoltaic device according to the present invention.

[FIG. 6] FESEM images of GZO films, deposited at substrate temperatures of (a) 200°C, (b) 135°C, (c) 60°C, and (d) 25°C.

[FIG. 7] Cross-sectional schematic views of a stacked structure of a tandem-type solar cell used in a calculation by electromagnetic wave analysis (FDTD method).

[FIG. 8] A graph illustrating the relationship between the amplitude of a fine texture structure and the short-circuit current in a stacked structure model.

[FIG. 9] A graph illustrating the relationship between the amplitude of a fine texture structure and the equivalent current of silver absorbed light in a stacked structure model.

[FIG. 10] A graph illustrating the relationship between the substrate temperature during deposition of the second transparent electrode layer and the short-circuit current of a tandem-type solar cell.

[FIG. 11] A graph illustrating the relationship between the substrate temperature during deposition of the second transparent electrode layer and the conversion efficiency of a tandem-type solar cell.

[FIG. 12] Reflectance spectra for samples in which a GZO film and a silver thin film are formed sequentially on a glass substrate (and light is irradiated through the glass substrate).

Explanation of Reference:

| 1: | Substrate |
| 2: | First transparent electrode layer |
| 3: | Photovoltaic layer |
| 4: | Back electrode layer |
| 5: | Intermediate contact layer |
| 6: | Second transparent electrode layer |
| 7: | Solar cell module |
| 31: | Amorphous silicon p-layer |
| 32: | Amorphous silicon i-layer |
| 33: | Amorphous silicon n-layer |
| 41: | Crystalline silicon p-layer |
| 42: | Crystalline silicon i-layer |

43: Crystalline silicon n-layer
91: First cell layer
92: Second cell layer
100: Photovoltaic device

Best Mode for Carrying Out the Invention

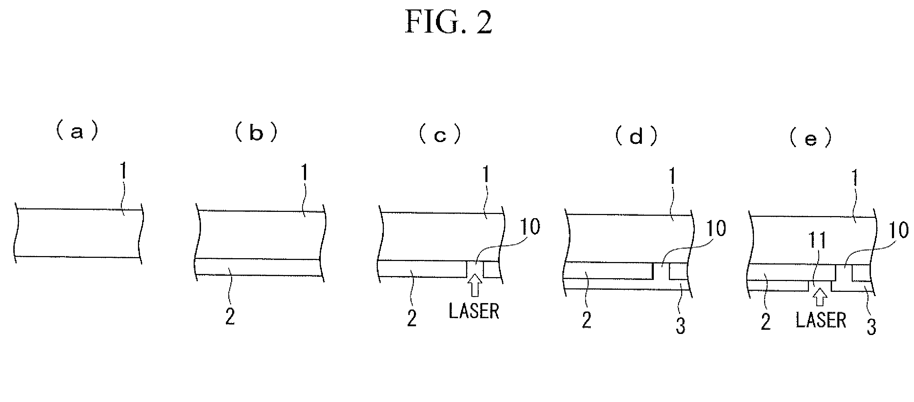

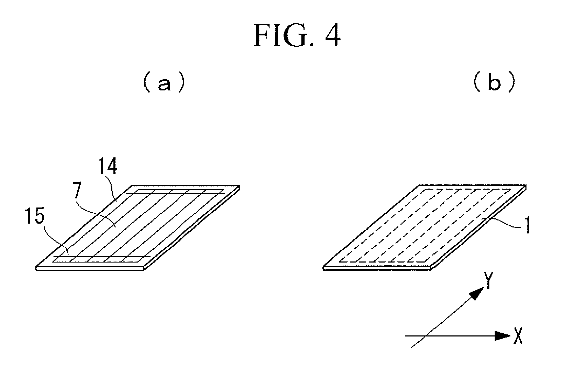

A description of the structure of an embodiment of a photovoltaic device of the present invention is presented below.

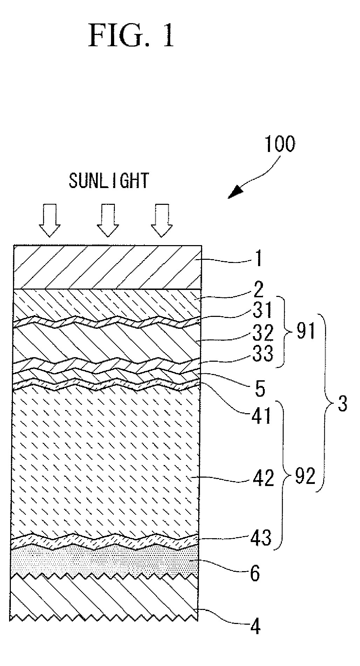

FIG. 1 is a schematic illustration of the structure of a photovoltaic device according to this embodiment. A photovoltaic device 100 is a silicon-based solar cell, and comprises a substrate 1, a first transparent electrode layer 2, a first cell layer 91 (an amorphous silicon series) and a second cell layer 92 (a crystalline silicon series) that function as a photovoltaic layer 3, and a second transparent electrode layer 6 and a back electrode layer 4 that function as the back surface structure. Here, the term "silicon-based" is a generic term that includes silicon (Si), silicon carbide (SiC) and silicon germanium (SiGe). Further, a crystalline silicon series describes a silicon series other than an amorphous silicon series, and includes both microcrystalline silicon series and polycrystalline silicon series.
A description of the steps for producing a photovoltaic device according to the present embodiment is presented below, using a solar cell panel as an example, with reference to FIG. 2 through FIG. 5.

(1) FIG. 2(a)

A soda float glass substrate (for example, a large surface area substrate of 1.4 m $\times$ 1.1 m $\times$ thickness: 3 to 6 mm, where the length of one side exceeds 1 m) is used as the substrate 1. The edges of the substrate are preferably subjected to corner chamfering or R-face chamfering to prevent damage caused by thermal stress or impacts or the like.

(2) FIG. 2(b)

A transparent electrode film comprising mainly tin oxide ($SnO_2$) and having a film thickness of approximately not less than 500 nm and not more than 800 nm is deposited as the first transparent electrode layer 2, using a thermal CVD apparatus at a temperature of approximately 500°C. During this deposition, a texture comprising suitable unevenness is formed on the surface of the transparent electrode film. In addition to the transparent electrode film, the first transparent electrode layer 2 may include an alkali barrier film (not shown in the figure) formed between the substrate 1 and the transparent electrode film. The alkali barrier film is formed using a thermal CVD apparatus at a temperature of approximately 500°C to deposit a silicon oxide film ($SiO_2$) having a film thickness of not less than 50 nm and not more than 150 nm.

(3) FIG. 2 (c)

Subsequently, the substrate 1 is mounted on an X-Y table, and the first harmonic of a YAG laser (1064 nm) is irradiated onto the surface of the first transparent electrode layer, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

(4) FIG. 2(d)

Using a plasma enhanced CVD apparatus, a p-layer, an i-layer and an n-layer, each composed of a thin film of amorphous silicon, are deposited as the first cell layer 91. Using $SiH_4$ gas and $H_2$ gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in this order, on the first transparent electrode layer 2, with the p-layer closest to the surface from which incident sunlight enters. The amorphous silicon p-layer 31 is an amorphous B-doped silicon film having a film thickness of not less than 10 nm and not more than 30 nm. The amorphous silicon i-layer 32 has a film thickness of not less than 200 nm and not more than 350 nm. The amorphous silicon n-layer 33 is a P-doped amorphous silicon film having a film thickness of not less than 30 nm and not more than 50 nm. Either a crystalline silicon film or a stacked structure of an amorphous silicon film and a crystalline silicon film may be formed instead of the amorphous silicon n-layer. A buffer layer may be provided between the amorphous silicon p-layer 31 and the amorphous silicon i-layer 32 in order to improve the interface properties.

Using a plasma enhanced CVD apparatus, a p-layer, an i-layer and an n-layer, each composed of a thin film of crystalline silicon, are deposited as the second cell layer 92 on top of the first cell layer 91. Using $SiH_4$ gas and $H_2$ gas as the main raw materials, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited in this order.

The crystalline silicon p-layer 41 is a B-doped crystalline silicon film having a film thickness of not less than 10 nm and not more than 50 nm. The crystalline silicon i-layer 42 has a film thickness of not less than 1.2 $\mu$m and not more than 3.0 $\mu$m. The crystalline silicon n-layer 43 is a P-doped crystalline silicon film having a film thickness of not less than 20 nm and not more than 50 nm.

In this embodiment, an intermediate contact layer 5 that functions as a semi-reflective film for improving the contact properties between the first cell layer 91 and the second cell layer 92 and achieving electrical current consistency may be provided on the first cell layer 91. For example, a GZO (Ga-doped ZnO) film with a film thickness of not less than 20 nm and not more than 100 nm may be deposited as the intermediate contact layer 5 using a DC sputtering apparatus with a Ga-doped ZnO sintered body as the target.

(5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a point approximately 100 $\mu$m to 150 $\mu$m to the side of the laser etching line within the first transparent electrode layer 2, so as to form a slot 11. The laser may also be irradiated from the side of the substrate 1. In this case, because the high vapor pressure generated by the energy absorbed by the first cell layer 91 of the photovoltaic layer 3 can be utilized, more stable laser etching processing can be performed. The position of the laser etching line is determined with due consideration of positioning tolerances, so as not to overlap with the previously formed etching line.

(6) FIG. 3(a)

The second transparent electrode layer 6 and the back electrode layer 4 are formed sequentially on top of the crystalline silicon n-layer 43 of the second cell layer 92.

A GZO film is deposited as the second transparent electrode layer 6 using a sputtering apparatus. Using a Ga-doped ZnO sintered body as the target, deposition is conducted under conditions including a discharge gas composed of argon and oxygen, a film thickness of not less than 50 nm and not more than 150 nm, and a substrate temperature of not less than 20°C and not more than 90°C, and preferably not less than 20°C and not more than 60°C.

Using a sputtering apparatus, an Ag film is deposited as the back electrode layer 4, using argon as the discharge gas and at a deposition temperature of approximately 150°C. Alternatively, an Ag film/Ti film stacked structure, formed by sequentially stacking an Ag film having a thickness of 200 to 500 nm and a highly corrosion-resistant Ti film having a thickness of 10 to 20 nm which acts as a protective film, may be formed as the back electrode layer 4. In this case, the Ag film is provided on the substrate-side of the stacked structure.

(7) FIG. 3(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 $\mu$m to 400 $\mu$m to the side of the laser etching line within the transparent electrode layer 2, so as to form a slot 12.

(8) FIG. 3(c)

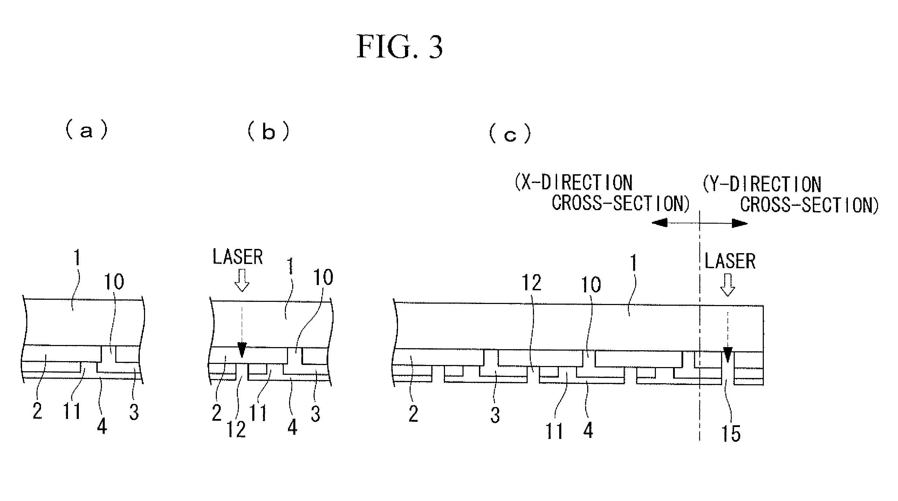

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). A Y-direction insulation slot need not be provided at this point, because a film surface polishing and removal treatment is conducted on the peripheral regions of the substrate 1 in a latter step.

Completing the etching of the insulation slot 15 at a position 5 to 10 mm from the edge of the substrate 1 is preferred, as it ensures that the insulation slot 15 is effective in inhibiting external moisture from entering the interior of the solar cell module 7 via the edges of the solar cell panel.

Although the laser light used in the steps until this point has been specifies as YAG laser light, light from a YVO4 laser or fiber laser or the like may also be used in a similar manner.

(9) FIG. 4(a)

In order to ensure favorable adhesion and sealing of a backing sheet 24 via EVA or the like in a subsequent step, the stacked films around the periphery of the substrate 1 (in a peripheral region 14) are removed, as they tend to be uneven and prone to peeling. Grinding or blast polishing or the like is used to remove the back electrode layer 4, the photovoltaic layer 3, and the transparent electrode layer 2 from a region that is 5 mm to 20 mm from the edge around the entire periphery of the substrate 1, is closer to the substrate edge than the insulation slot 15 provided in the above step of FIG. 3(c) in the X direction, and is closer to the substrate edge than the slot 10 near the substrate edge in the Y direction. Grinding debris or abrasive grains are removed by washing the substrate 1.

(10) FIG. 4(b)

A terminal box attachment portion is prepared by providing an open through-window in the backing sheet 24 and exposing a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, in order to enable electric power to be extracted from a terminal box portion on the rear surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 7 is covered with a sheet of an adhesive filling material such as EVA (ethylene-vinyl acetate copolymer) arranged so as not to protrude beyond the substrate 1.

A backing sheet 24 with a superior waterproofing effect is positioned on top of the EVA. In this embodiment, in order to achieve a superior waterproofing and moisture-proofing effect, the backing sheet 24 is formed as a three-layer structure comprising a PET sheet, an Al foil, and a PET sheet.

The structure comprising the components up to and including the backing sheet 24 arranged in predetermined positions is subjected to internal degassing under a reduced pressure atmosphere and pressing at approximately 150°C to 160°C using a laminator, thereby causing cross-linking of the EVA that tightly seals the structure.

(11) FIG. 5(a)

A terminal box 23 is attached to the back of the solar cell module 7 using an adhesive.

(12) FIG. 5(b)

The copper foil and an output cable from the terminal box 23 are connected using solder or the like, and the interior of the terminal box is filled and sealed with a sealant (a potting material). This completes the production of the solar cell panel 50.

(13) FIG. 5(c)

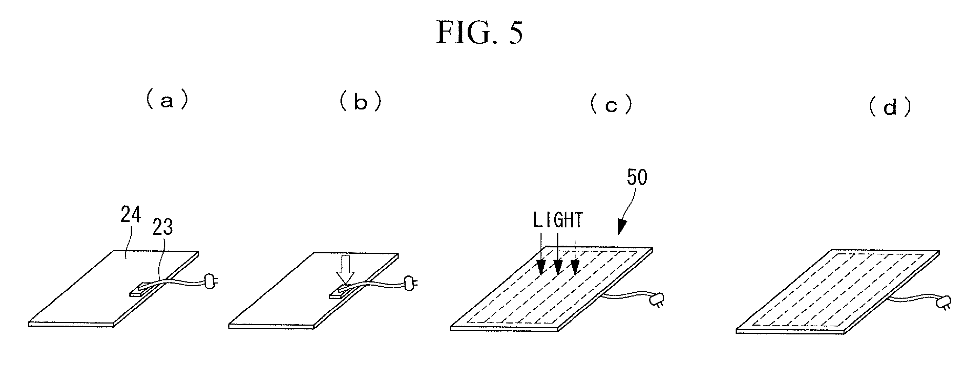

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 ($1,000 W/m^2$).

(14) FIG. 5(d)

In tandem with the electric power generation test (FIG. 5(c)), a variety of specific performance factors including the external appearance are evaluated.

In a solar cell produced via the steps described above, as shown in FIG. 1, the surface of the second transparent electrode layer 6 on the side of the back electrode layer 4 has a fine uneven texture, and is a surface of favorable smoothness for which the surface area magnification ratio relative to the projected surface area is not less than 10% and not more than 32%.

The surface area magnification ratio can be calculated using the formula (1) above, from the value for the three dimensional surface area (S), which is obtained from an atomic force microscope (AFM) image of the back electrode layer-side surface of the second transparent electrode layer within a predetermined field of view, and the value for the two dimensional projected surface area (So), which is generated by projecting the back electrode layer-side surface of the second transparent electrode layer within the predetermined field of view onto a flat plane.

Furthermore, the second transparent electrode layer 6 of the solar cell produced via the steps described above comprises needle-like crystals, which grow through the film thickness direction, with a single crystal structure penetrating right through the electrode layer in the film thickness direction. By ensuring that the electrode layer comprises needle-like crystals having an aspect ratio (namely, the ratio of the length of the needle-like crystals through the film thickness direction relative to the length in the in-plane direction within the second transparent electrode layer) of not less than 2.2, and preferably not less than 2.5, and even more preferably 2.8 or greater, the microscopic structure at the surface of the second transparent electrode layer 6 on the side of the back electrode layer 4 becomes denser, and the height variation within the surface unevenness is reduced, meaning a film of favorable smoothness is obtained.

Because the length in the film thickness direction of the crystal structures of the second transparent electrode layer is such that a single crystal structure penetrates right through the electrode layer in the film thickness direction, the length of the crystal is equal to the film thickness of the second transparent electrode layer. The film thickness of the second transparent electrode layer can be obtained by various methods, including measurement of a cross-sectional photograph from a field emission scanning electron microscope (FESEM), measurement of level differences, and calculation based on the deposition conditions using a calibration curve of known deposition conditions and film thickness values. The length of the crystal structures along the in-plane direction within the second transparent electrode layer can be obtained by power spectrum density (PSD) analysis of an atomic force microscope (AFM) image, by determining the frequency where the power spectrum density reaches a maximum.

The back electrode layer 4 has a surface shape that conforms to the surface of the second transparent electrode layer 6 on the side of the back electrode layer 4. In other words, as shown in FIG. 1, the shape of the substrate-side surface of the back electrode layer 4 is substantially the same as the back electrode layer-side surface of the second transparent electrode layer 6. Because the substrate-side surface of the back electrode layer 4 has this type of surface shape, light loss due to surface plasmon absorption at the back electrode layer 4 is reduced, and the quantity of reflected light is increased. Accordingly, a solar cell according to the present embodiment exhibits increased short-circuit current at the electric power generation layer, and has superior output and high conversion efficiency.

The shape of the surface of the second transparent electrode layer 6 on the side of the back electrode layer 4 in a solar cell of the present embodiment can be confirmed, for example, by exposing the second transparent electrode layer 6 by removing the back electrode layer 4, either by chemical removal using a chemical agent or by peeling, and then inspecting the second transparent electrode layer 6 using an AFM or FESEM.

Examples

(Effect of substrate temperature during deposition on the surface shape of a GZO film surface)

A GZO film was deposited on a glass substrate. Using a DC sputtering apparatus with a Ga-doped ZnO sintered body as the target, film deposition was conducted under conditions including a discharge gas composed of argon and oxygen, a film thickness target of 80 nm, and a substrate temperature of 25°C, 60°C, 135°C or 200°C.

The surface shapes of the GZO films deposited at each of the different substrate temperatures were inspected using an AFM (NanoScope D-3100, manufactured by Digital Instruments Inc.), with each sample inspected using a tapping mode within two arbitrary fields of view, under conditions including a field of view of 2 $\mu$m $\times$ 2 $\mu$m, a resolution of 512 pixels, and a Z-range of either 100 nm/div or 500 nm/div. An average value for the surface area magnification ratio was determined from the obtained AFM images. Using a cross-sectional profile of the AFM image, the height and width (the distance between a peak and an adjacent valley) of the uneven texture was measured at 15 randomly extracted points within each field of view (a total of 30 points), and average values were calculated for the height and width of the uneven texture. A one dimensional power spectrum density analysis of the AFM image was also conducted. The power spectrum density horizontal axis represents the frequency, and is the distance dimension. In the case of a surface shape having a distinctive structure occurring at a certain distance separation, a peak is displayed at the frequency corresponding with that distance. In other words, the frequency that yields a maximum for the power spectrum density represents the pitch of the surface shape.

The GZO films deposited at each of the different substrate temperatures were inspected using an FESEM (FESEM JSM-6301F, manufactured by JEOL Ltd.) under conditions including an accelerating voltage of 3 keV and a magnification of 100,000×, using a Pt coating as the conductive coating.

Table 1 shows the surface area magnification ratio for the GZO film deposited at each of the substrate temperatures, as well as the height and width of the uneven texture obtained from the AFM image. A higher substrate temperature tended to yield a larger surface area magnification ratio and greater height of the uneven texture. Further, a higher substrate temperature during deposition resulted in the detection of a higher power spectrum density. In other words, a higher substrate temperature results in a larger height variation within the fine uneven texture on the surface. Moreover, the higher the substrate temperature becomes, the larger the value of the frequency at which the power spectrum density exhibits a maximum. In other words, a higher substrate temperature results in coarser crystals and a larger pitch for the fine uneven texture.

[Table 1]

| Substrate temperature (°C) | Surface area magnification ratio (%) | Height of uneven texture (nm) | Width of uneven texture (nm) |
|---|---|---|---|
| 200 | 7.8 | 10 | 38 |
| 135 | 5.4 | 8 | 40 |
| 60 | 4.6 | 5 | 21 |
| 25 | 0.8 | 3 | 37 |

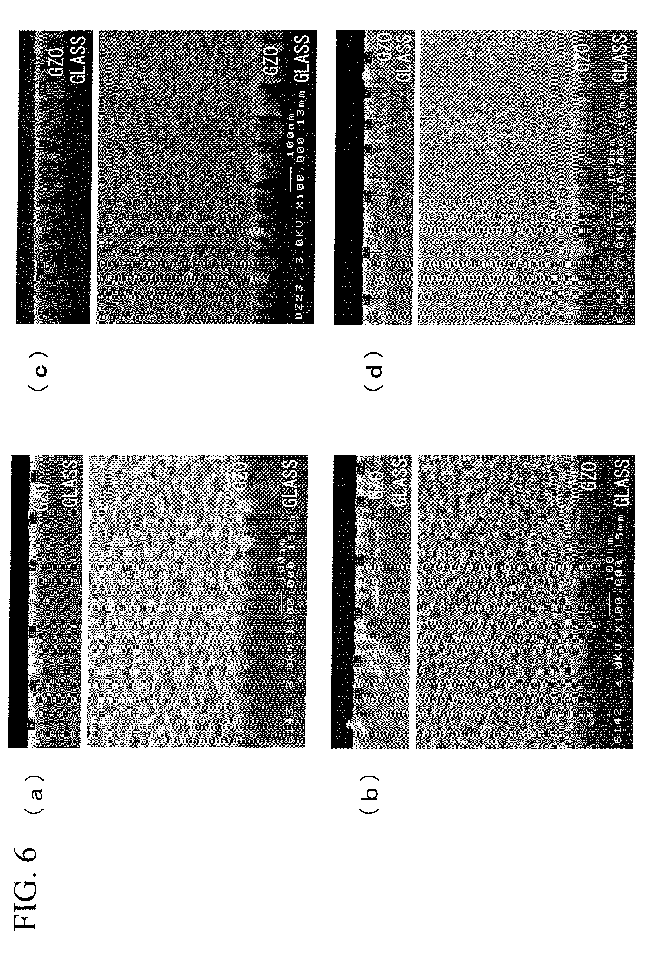

FIG. 6 is a series of FESEM images of GZO films deposited at substrate temperatures of (a) 200°C, (b) 135°C, (c) 60°C, and (d) 25°C. The GZO films deposited at substrate temperatures of 200°C and 135°C comprised granular crystal structures (with aspect ratios of 1.5 and 2.1 respectively), and a large uneven texture was observed on the surface. In contrast, the GZO films deposited at substrate temperatures of 60°C and 25°C comprised needle-like crystal structures (with aspect ratios of 3.1 and 2.8 respectively) that exhibited considerable length across the film thickness direction (the direction of crystal growth), and the uneven texture on the surface was very fine. In determining the aspect ratios, the length across the film thickness direction was determined by inspecting a cross-section of the GZO film on the glass substrate using a FESEM and measuring the film thickness. The length in the width direction was defined as the frequency that yielded a maximum for the power spectrum density obtained by conducting a surface shape analysis of the GZO film on the glass substrate using an AFM.

The above results confirmed that there was a correlation between the substrate temperature during deposition and the surface shape of the GZO film.

(Calculation of short-circuit current and surface plasmon absorption for a solar cell)

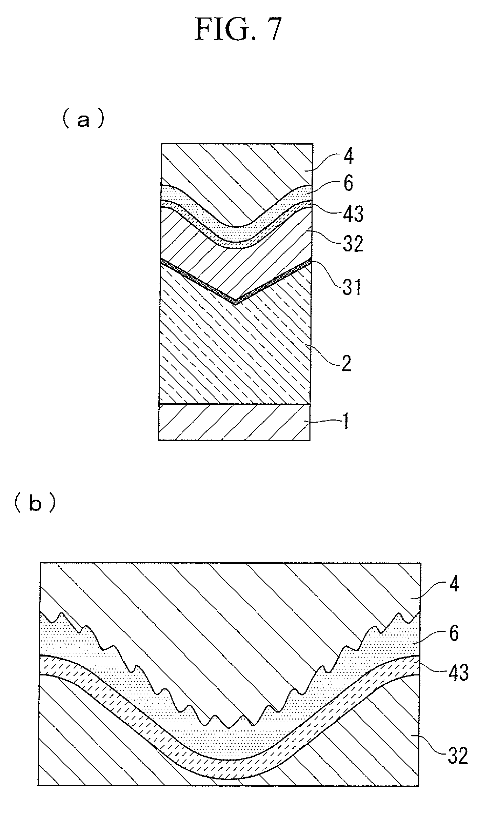

Based on the results in Table 1, a stacked structure model of a solar cell shown in FIG. 7 was developed with due consideration of the uneven texture on the surface of the GZO film (the second transparent electrode layer), and an electromagnetic wave analysis (FDTD method) was conducted.

The stacked structure model of FIG. 7(a) represents a single layer solar cell, wherein a first transparent electrode layer 2, an amorphous silicon p-layer 31, an amorphous silicon i-layer 32 and a crystalline silicon n-layer 43 that function as the electric power generation layer, a second transparent electrode layer 6, and a back electrode layer 4 are stacked on, in this order, a glass substrate 1.

The texture structure of the first transparent electrode layer 2 was designed with an average pitch (the width of one period) of 600 nm, an inclination angle (the angle from the substrate surface) of 30°, and an average film thickness of 500 nm. The average pitch and inclination angle are representative values determined by AFM analysis of the surface shape of the first transparent electrode layer (haze: 20%) deposited on the glass substrate.

The film thickness of the p-layer 31 was set to 10 nm, and the texture structure of the upper and lower surfaces of the layer conformed to the texture structure of the upper surface of the first transparent electrode layer 2. The film thickness of the i-layer 32 was set to 200 nm, wherein the texture structure of the lower surface was the same as that of the p-layer 31, whereas the texture structure of the upper surface was defined using a sine function with the same pitch as the texture of the first transparent electrode layer 2. Following deposition of the i-layer 32, representative dimensions determined by conducting an AFM analysis of the surface shape were used to prescribe the amplitude of the sine function. The film thickness of the n-layer 43 was set to 30 nm, and the texture structure of the upper and lower surfaces of the layer conformed to the texture structure of the upper surface of the i-layer.

The second transparent electrode layer 6 (GZO film) had an average film thickness of 60 nm. The texture structure of the lower surface of the second transparent electrode layer 6 conformed to the texture of the n-layer 43. The texture structure of the upper surface of the second transparent electrode layer 6, as shown in FIG. 7(b), was a shape in which a fine texture structure defined by a sine function existed on a larger texture structure having the same shape as that of the n-layer 43.

The back electrode layer 4 was a silver thin film with an average film thickness of 250 nm. The lower surface texture of the back electrode layer 4 was the same as the upper surface texture of the second transparent electrode layer 6.

The amplitude and pitch of the fine texture structure were determined on the basis of the height and width values for the uneven textures of the GZO single films shown in Table 1. The amplitude (height) and pitch (twice the width) of the fine texture structure of the second transparent electrode layer 6 were varied within ranges from 0 to 20 nm and 30 to 120 nm respectively, and the short-circuit current and the equivalent current of silver absorbed light were calculated. An amplitude of 0 nm represents the case where no fine texture structure exists. The short-circuit current represents the quantity of light absorbed by the amorphous silicon i-layer, converted to an electrical current value for a sunlight spectrum of AM 1.5. The equivalent current of silver absorbed light represents the quantity of light absorbed at the substrate-side surface of the back electrode layer, converted to an electrical current value for a sunlight spectrum of AM 1.5.

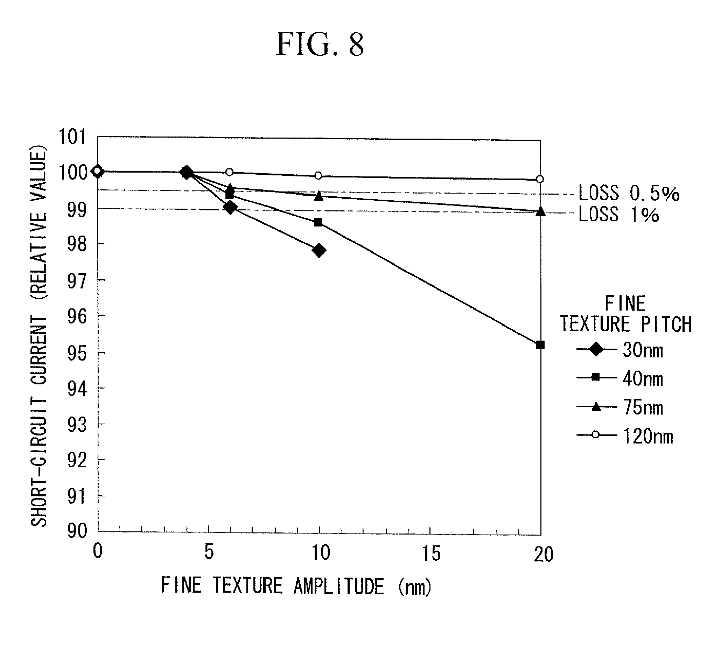

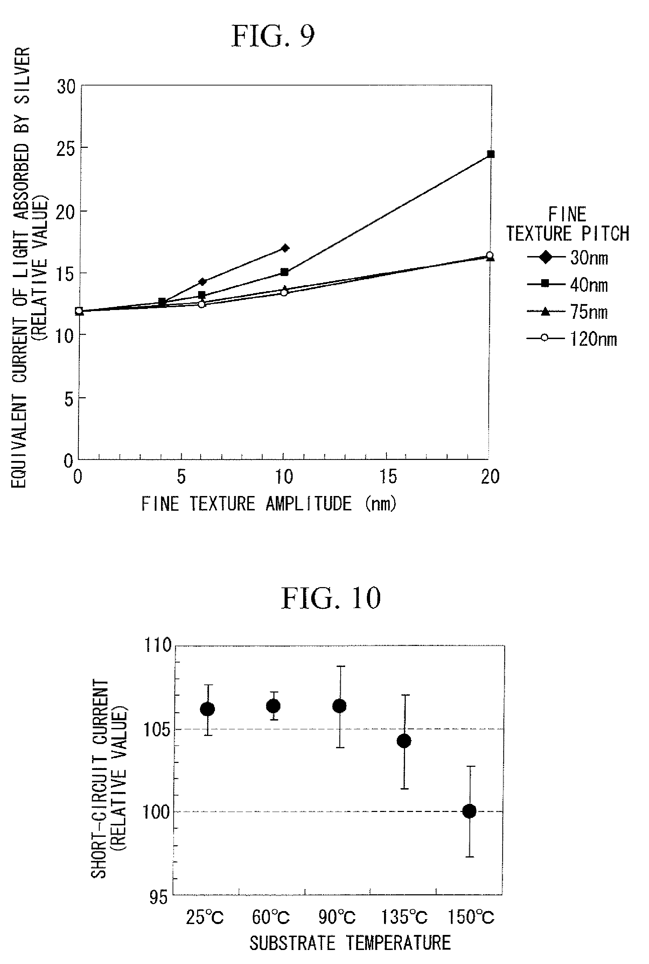

FIG. 8 is a graph illustrating the relationship between the amplitude of the fine texture structure and the short-circuit current. In this figure, the horizontal axis represents the amplitude, and the vertical axis represents the relative value of the short-circuit current referenced against the short-circuit current value in the case where the amplitude of the fine texture is 0 nm. FIG. 9 is a graph illustrating the relationship between the amplitude of the fine texture structure and the equivalent current of silver absorbed light. In this figure, the horizontal axis represents the amplitude, and the vertical axis represents the relative value of the equivalent current of silver absorbed light referenced against the short-circuit current value in the case where the amplitude of the fine texture is 0 nm.

The larger the amplitude of the fine texture became, the more the short-circuit current decreased. Comparing results at the same amplitude revealed that the short-circuit current tended to decrease as the pitch of the fine texture decreased. The equivalent current of silver absorbed light exhibited the opposite tendency to the short-circuit current, and tended to increase when the amplitude of the fine texture was large, and increase when the pitch was small. The results of FIG. 8 and FIG. 9 indicate that increasing the pitch of the fine texture of the second transparent electrode layer (namely, increasing the GZO crystal size) and reducing the amplitude (thereby making the fine texture structure closer to a mirror surface) are effective in increasing the short-circuit current.

In FIG. 8, lines representing a current loss of 0.5% and a current loss of 1% from the short-circuit current when the amplitude is 0 nm are shown as judgment lines for evaluating the short-circuit current loss. When the amplitude (height) and pitch (twice the width) of the GZO films deposited at the substrate temperatures shown in Table 1 were plotted on FIG. 8, the values for substrate temperatures of 135°C and 200°C (amplitude: 8 to 10 nm, pitch: 80 nm) satisfied the first criterion for evaluating short-circuit current loss (the 1% loss line), but fell below the second criterion (the 0.5% loss line). The values for substrate temperatures of 25°C and 60°C (amplitude: 3 to 5 nm, pitch: 40 to 80 nm) satisfied both the first and second criteria for evaluating short-circuit current loss.

The above results revealed the following observations.
When the second transparent electrode layer is deposited at a substrate temperature of 90°C or lower (for example, 25°C or 60°C), the amplitude of the fine texture on the back electrode layer-side surface of the second transparent electrode layer is small. Further, a GZO film deposited at a low temperature exhibits a dense needle-like crystal structure (aspect ratio: 2.2 or greater). In other words, in a solar cell in which a GZO film is deposited at a low temperature as the second transparent electrode layer, the surface area magnification ratio is small and the surface is close to a mirror-like state, and it is thought that as a result, surface plasmon absorption at the back electrode layer (silver) surface is reduced, enabling an increase in the quantity of light reflected off the back electrode layer surface. As a result, it is presumed that any decrease in the electrical current generated by the electric power generation layer (namely, the short-circuit current) can be suppressed, and reductions in the conversion efficiency can also be suppressed.

In contrast, when the second transparent electrode layer is deposited at a substrate temperature exceeding 90°C (for example, 135°C or 200°C), the amplitude of the fine texture on the back electrode layer-side surface of the second transparent electrode layer is large. Further, a GZO film deposited at a high temperature exhibits a granular crystal structure having a small aspect ratio, and the degree of unevenness at the surface is large. In other words, in a solar cell in which a GZO film is deposited at a high temperature as the second transparent electrode layer, the surface area magnification ratio is large and the surface is rough, and it is thought that as a result, surface plasmon absorption is large, and the quantity of light reflected off the back electrode layer surface is small. As a result, it is presumed that the short-circuit current generated by the electric power generation layer will decrease, and the conversion efficiency will fall.

(Relationship between substrate temperature during deposition of the second transparent electrode layer and solar cell performance)

An amorphous silicon single-type stacked structure was prepared by sequentially forming, on top of a glass substrate, a first transparent electrode layer, a p-layer, an i-layer and an n-layer as an amorphous silicon electric power generation layer, and a second transparent electrode layer.
A $SnO_2$ film having a film thickness of 700 nm was deposited as the first transparent electrode layer. The amorphous silicon electric power generation layer was deposited using a plasma enhanced CVD apparatus, wherein the p-layer film thickness was 10 nm, the i-layer film thickness was 200 nm, and the n-layer film thickness was 30 nm. A GZO film was deposited as the second transparent electrode layer using a DC sputtering apparatus with a Ga-doped ZnO sintered body as the target, under conditions including a discharge gas composed of argon and oxygen, and a substrate temperature of 60°C or 135°C. When deposition was conducted at a substrate temperature of 60°C, the GZO film thickness was 100 nm, whereas when deposition was conducted at a substrate temperature of 135°C, the GZO film thickness was 60 nm.

An tandem-type stacked structure was prepared by sequentially forming, on top of a glass substrate, a first transparent electrode layer, a first cell layer, an intermediate contact layer, a second cell layer, and a second transparent electrode layer. The first cell layer and the second cell layer were each prepared by depositing a p-layer, an i-layer and an n-layer in sequence from the substrate side.
A $SnO_2$ film having a film thickness of 700 nm was deposited as the first transparent electrode layer. The first cell layer, composed of amorphous silicon, was deposited using a plasma enhanced CVD apparatus, and the p-layer film thickness was 10 nm, the i-layer film thickness was 200 nm, and the n-layer film thickness was 30 nm. A GZO film having a film thickness of 70 nm was formed as the intermediate contact layer. The second cell layer, composed of crystalline silicon, was deposited using a plasma enhanced CVD apparatus, and the p-layer film thickness was 30 nm, the i-layer film thickness was 2,000 nm, and the n-layer film thickness was 30 nm. The second transparent electrode layer was deposited using a DC sputtering apparatus with a Ga-doped ZnO sintered body as the target, under conditions including a discharge gas composed of argon and oxygen, and a substrate temperature of 60°C or 135°C. When deposition was conducted at a substrate temperature of 60°C, the GZO film thickness was 100 nm, whereas when deposition was conducted at a substrate temperature of 135°C, the GZO film thickness was 60 nm.

For comparison, a tandem-type stacked structure having no second transparent electrode layer was also prepared. The first transparent electrode layer, the first cell layer, the intermediate contact layer, and the second cell layer were formed in the same manner as the above tandem-type stacked structure that included a second transparent electrode layer.

The surface of the second transparent electrode layer or the surface of the second cell n-layer (in the case of the tandem-type stacked structure having no second transparent electrode layer) was analyzed using an AFM, and the surface area magnification ratio was determined in each case. The results are shown in Table 2.

[Table 2]

| | Substrate temperature | Surface area magnification ratio (%) | |
| --- | --- | --- | --- |
| | | | Average value |
| Amorphous silicon single-type structure | 60°C | 29.0<br>31.2 | 30.1 |
| | 135°C | 36.2<br>35.5 | 33.0 |
| Tandem-type structure | 60°C | 30.3<br>29.2 | 29.8 |
| | 135°C | 33.5<br>39.0 | 36.3 |
| | (No second transparent electrode layer) | 9.3<br>8.0<br>7.9<br>8.5 | 8.4 |

In these examples, a first transparent electrode layer having a large degree of surface unevenness was formed, and therefore the surface area magnification ratio values were larger than the values shown in Table 1 in which a GZO film was deposited on the glass substrate. Further, the surface area magnification ratio of the surface of the n-layer of the second cell layer was less than 10%. In contrast, the surface area magnification ratio of the surface of the second transparent electrode layer increased. In both the single-type structure and the tandem-type structure, the second transparent electrode layer deposited at a substrate temperature of 60°C exhibited a surface area magnification ratio of 32% or less. In the case of deposition at a substrate temperature of 135°C, the surface area magnification ratio for the second transparent electrode layer was larger than that observed at a substrate temperature of 60°C.

In this manner, the surface area magnification ratio for the second transparent electrode layer was dependent on the substrate temperature during deposition, for both the single-type solar cell and the tandem-type solar cell. Accordingly, even in the case of the tandem-type solar cell, it is thought that in those cases where the substrate temperature during deposition of the second transparent electrode layer was low, the second transparent electrode layer adopted a needle-like crystal structure, and the amplitude of the fine texture structure was reduced, meaning the surface shape of the second transparent electrode layer was close to a smooth surface.

Tandem-type solar cells (substrate: 5 cm square) were prepared with various substrate temperatures during deposition of the second transparent electrode layer. A GZO film with a film thickness of 60 nm was deposited as the second transparent electrode layer at a substrate temperature of 25°C, 60°C, 90°C, 135°C or 150°C. Following formation of a back electrode layer, an annealing treatment was conducted in a nitrogen atmosphere at a temperature of 160°C for a period of 2 hours.

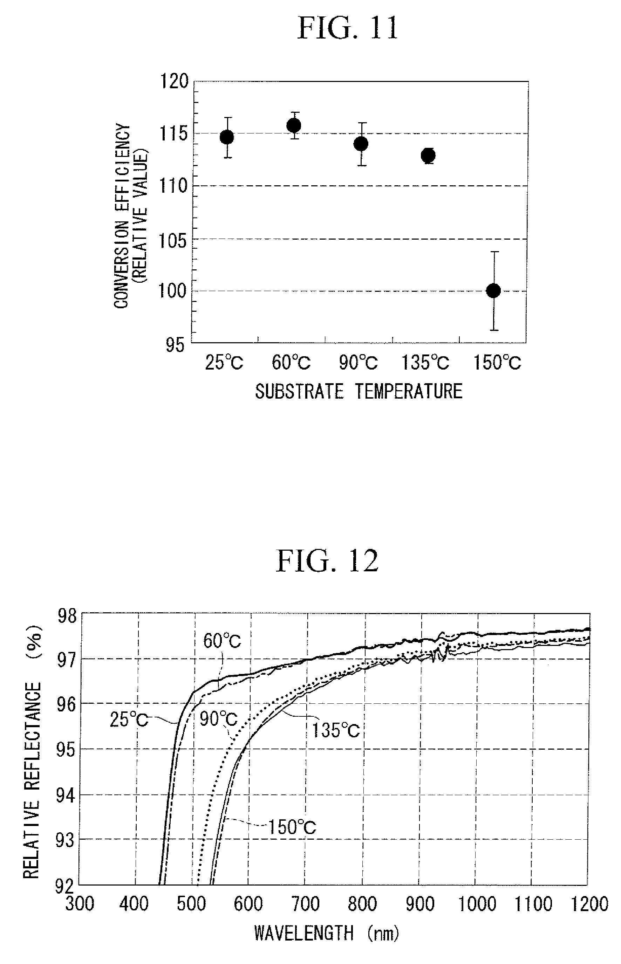

The short-circuit current and the conversion efficiency were measured for each of the prepared tandem-type solar cells. FIG. 10 shows the average value and standard deviation for the short-circuit current. In this figure, the horizontal axis represents the substrate temperature during deposition of the second transparent electrode layer, and the vertical axis represents the relative value for the short-circuit current referenced against the short-circuit current for a substrate temperature of 150°C. FIG. 11 shows the average value and standard deviation for the conversion efficiency. In this figure, the horizontal axis represents the substrate temperature during deposition of the second transparent electrode layer, and the vertical axis represents the relative value for the conversion efficiency referenced against the conversion efficiency at a substrate temperature of 150°C. The values for the short-circuit current and the conversion efficiency represent the average values for measurements conducted at 15 different points on each cell having a 5 cm square substrate surface, across a total of 5 substrates, but excluding any cells spoiled as a result of mistakes in the laser etching processes.

As illustrated in FIG. 10, those solar cells in which the second transparent electrode layer was deposited at a substrate temperature of not more than 90°C exhibited a larger short-circuit current than those solar cells in which the second transparent electrode layer was deposited at a conventional substrate temperature of 135°C or 150°C. In keeping with the increase in the short-circuit current, as shown in FIG. 11, the conversion efficiency also increased for those solar cells in which the second transparent electrode layer was deposited at a substrate temperature of not more than 90°C. In solar cells in which the second transparent electrode layer was deposited at a substrate temperature of not more than 90°, because the open-circuit voltage and fill factor also increased together with the short-circuit current, the conversion efficiency values shown in FIG. 11 increased by a greater amount than that due solely to the contribution of the short-circuit current increase.

FIG. 10 and FIG. 11 show the results for individual solar cells, but for example, even in the case of a large surface area solar cell module having a substrate size of 1.4 m × 1.1 m, an increase in the module output due to a similar increase in the short-circuit current (an increase in the electrical power output of approximately 3% relative to a conventional module) has also been confirmed.

FIG. 12 illustrates spectral reflectance spectra for samples in which a GZO film and a silver thin film are formed sequentially on a glass substrate (substrate temperature during GZO deposition: 25°C, 60°C, 90°C, 135°C and 150°C), and light is irradiated through the glass substrate. The glass substrate was #1737 glass manufactured by Corning Incorporated (substrate thickness: 1 mmt). In this figure, the horizontal axis represents the wavelength and the vertical axis represents the reflectance. The absorption wavelength band for the second cell layer of a tandem-type solar cell is within a wavelength range from 600 nm to 1,000 nm. In those cases where the GZO film was deposited at a substrate temperature of 135°C or 150°C, the reflectance within the absorption wavelength band for the second cell layer was low, and the reflectance decreased dramatically for wavelengths of 900 nm or shorter. When the GZO film was deposited at a substrate temperature of 90°C, the reflectance improved for shorter wavelengths. When the GZO film was deposited at a substrate temperature of 25°C or 60°C, a high reflectance was obtained across the entire absorption wavelength band for the second cell layer.

In a tandem-type solar cell, as shown in Table 2, the shape of the back electrode-side surface of the second transparent electrode layer was dependent on the substrate temperature during deposition, and it is thought that provided the deposition is conducted at a temperature of not more than 90°C (60°C in Table 2), a fine uneven texture close to a flat surface is obtained. Furthermore, from the reflectance spectra of FIG. 12, it was evident that by conducting the deposition at a low temperature, a high reflectance was obtained across the entire absorption wavelength band for the second cell layer. Accordingly, in a tandem-type solar cell in which deposition of the second transparent electrode layer is conducted at 90°C or lower, it was predicted that surface plasmon absorption caused by fine uneven texture on the substrate-side surface of the back electrode layer could be suppressed, and that reductions in the short-circuit current and the conversion efficiency could also be suppressed. This prediction matches the results shown in FIG. 10 and FIG. 11.

In the above embodiments and examples, the description used an amorphous silicon single-type solar cell and a tandem-type solar cell as examples, but the present invention is not limited to these structures. For example, the present invention may also be applied to crystalline silicon single-type solar cells, crystalline SiGe single-type solar cells, and triple-type solar cells in which electric power generation layers of amorphous silicon, crystalline silicon and crystalline SiGe or the like are stacked sequentially so that the band gap widens from the light-incident surface of the cell.

**Claims**

1. A photovoltaic device comprising a first transparent electrode layer, an electric power generation layer, a second transparent electrode layer and a back electrode layer provided sequentially on a substrate, wherein
   the back electrode layer comprises a thin film of silver,
   a back electrode layer-side surface of the second transparent electrode layer has a fine uneven texture, and
   a surface area magnification ratio relative to a projected surface area of the back electrode layer-side surface of the second transparent electrode layer is not less than 10% and not more than 32%.

2. A photovoltaic device comprising a first transparent electrode layer, an electric power generation layer, a second transparent electrode layer and a back electrode layer provided sequentially on a substrate, wherein
   the back electrode layer comprises a thin film of silver,
   a back electrode layer-side surface of the second transparent electrode layer has a fine uneven texture, and
   the second transparent electrode layer comprises needle-like crystals.

3. The photovoltaic device according to Claim 2, wherein a ratio of a length of the needle-like crystals in a direction through a film thickness of the second transparent electrode layer relative to a length of the needle-like crystals in an in-plane direction of the second transparent electrode layer is not less than 2.2.

4. A photovoltaic device according to any one of Claim 1 through Claim 3, wherein the electric power generation layer comprises two or more cell layers, and
   at least one intermediate contact layer is provided between one of the cell layers and another of the cell layers that is closest to said one of the cell layers.

5. A process for producing a photovoltaic device, comprising:

   sequentially forming a first transparent electrode layer, an electric power generation layer, a second transparent electrode layer and a back electrode layer on a substrate, wherein
   the back electrode layer comprises a silver thin film, and
   the second transparent electrode layer is formed at a substrate temperature of not less than 20°C and not more than 90°C.

6. The process for producing a photovoltaic device according to Claim 5, wherein the second transparent electrode layer is formed so that a surface area magnification ratio relative to a projected surface area of the back electrode layer-side surface of the second transparent electrode layer is not less than 10% and not more than 32%.

7. The process for producing a photovoltaic device according to Claim 5 or Claim 6, wherein the second transparent electrode layer comprises needle-like crystals.

8. The process for producing a photovoltaic device according to Claim 7, wherein a ratio of a length of the needle-like crystals in a direction through a film thickness of the second transparent electrode layer relative to a length of the needle-like crystals in an in-plane direction of the second transparent electrode layer is not less than 2.2.

# FIG. 1

SUNLIGHT

100

1
2
31
32
33
5
41
42
43
6
4

91
92
3

# FIG. 2

(a)  (b)  (c)  (d)  (e)

EP 2 190 029 A1

# FIG. 3

（ａ）　　　　（ｂ）　　　　　（ｃ）

（X-DIRECTION
CROSS-SECTION)

（Y-DIRECTION
CROSS-SECTION)

FIG. 4

（a）                                                        （b）

# FIG. 5

(a)        (b)        (c)        (d)

EP 2 190 029 A1

FIG. 6

(a)

(b)

(c)

(d)

# FIG. 7

(a)

(b)

# FIG. 8

# FIG. 9

# FIG. 10

# FIG. 11

# FIG. 12

## INTERNATIONAL SEARCH REPORT

| | International application No. |
|---|---|
| | PCT/JP2009/050178 |

A. CLASSIFICATION OF SUBJECT MATTER
*H01L31/04(2006.01)i*

According to International Patent Classification (IPC) or to both national classification and IPC

B. FIELDS SEARCHED

Minimum documentation searched (classification system followed by classification symbols)
H01L31/04

Documentation searched other than minimum documentation to the extent that such documents are included in the fields searched

| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 6-338623 A (Asahi Glass Co., Ltd.), 06 December, 1994 (06.12.94), Par. Nos. [0014], [0017]; Fig. 1 (Family: none) | 1-8 |
| X | JP 2005-244073 A (National Institute of Advanced Industrial Science and Technology), 08 September, 2005 (08.09.05), Par. No. [0060]; Fig. 1 (Family: none) | 1-8 |
| Y | JP 2003-188401 A (Mitsubishi Heavy Industries, Ltd.), 04 July, 2003 (04.07.03), Fig. 1 (Family: none) | 4 |

| ☒ | Further documents are listed in the continuation of Box C. | ☐ See patent family annex. |
|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 04 February, 2009 (04.02.09) | 17 February, 2009 (17.02.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/050178

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2003-298088 A  (Kaneka Corp.),<br>17 October, 2003 (17.10.03),<br>Fig. 2<br>(Family: none) | 4 |
| A | JP 5-218469 A  (Canon Inc.),<br>27 August, 1993 (27.08.93),<br>Par. No. [0063]<br>& US 5500055 A          & US 5589403 A<br>& US 5885725 A          & US 5981867 A<br>& US 6061977 A          & EP 554877 A1 | 1-8 |
| A | JP 7-297421 A  (Canon Inc.),<br>10 November, 1995 (10.11.95),<br>Par. No. [0038]<br>& US 5603778 A | 1-8 |
| A | JP 11-29896 A  (Canon Inc.),<br>02 February, 1999 (02.02.99),<br>Par. No. [0035]<br>(Family: none) | 1-8 |
| A | JP 2000-252497 A  (Kaneka Corp.),<br>14 September, 2000 (14.09.00),<br>Par. No. [0043]<br>(Family: none) | 1-8 |
| A | JP 2001-85722 A  (Mitsubishi Heavy Industries,<br>Ltd.),<br>30 March, 2001 (30.03.01),<br>Par. No. [0059]<br>(Family: none) | 1-8 |
| A | JP 2003-86025 A  (Sanyo Electric Co., Ltd.),<br>20 March, 2003 (20.03.03),<br>Par. Nos. [0002] to [0005]<br>& US 2003/0059625 A1 | 1-8 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP SHO6041878 B